(19) Europäisches Patentamt
European Patent Office
Office européen des brevets

(11) **EP 4 564 020 B1**

(12) **EUROPÄISCHE PATENTSCHRIFT**

(45) Veröffentlichungstag und Bekanntmachung des Hinweises auf die Patenterteilung:
**15.04.2026 Patentblatt 2026/16**

(21) Anmeldenummer: **24212986.4**

(22) Anmeldetag: **14.11.2024**

(51) Internationale Patentklassifikation (IPC):
*G01R 27/00* *(2006.01)*      *G01R 31/00* *(2006.01)*
*G01R 27/02* *(2006.01)*      *C25B 15/06* *(2006.01)*
*G01R 27/18* *(2006.01)*      *G01R 31/52* *(2020.01)*

(52) Gemeinsame Patentklassifikation (CPC):
**G01R 27/18; C25B 15/06; G01R 27/025; G01R 31/52**

(54) **VERFAHREN UND ISOLATIONSÜBERWACHUNGS-ANORDNUNG FÜR EINE MIT EINER VERSORGUNGS-GLEICHSPANNUNG BETRIEBENE, FUNKTIONSGEERDETE ELEKTRISCHE ANLAGE**

METHOD AND INSULATION MONITORING ARRANGEMENT FOR A FUNCTIONALLY-GROUND ELECTRICAL SYSTEM OPERATED WITH A DC VOLTAGE SUPPLY

PROCÉDÉ ET DISPOSITIF DE SURVEILLANCE D'ISOLATION POUR UNE INSTALLATION ÉLECTRIQUE FONCTIONNANT AVEC UNE TENSION CONTINUE D'ALIMENTATION

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **24.11.2023 DE 102023132796**

(43) Veröffentlichungstag der Anmeldung:
**04.06.2025 Patentblatt 2025/23**

(73) Patentinhaber: **Bender GmbH & Co. KG 35305 Grünberg (DE)**

(72) Erfinder: **HACKL, Dieter 35463 Fernwald (DE)**

(74) Vertreter: **advotec. Patent- und Rechtsanwaltspartnerschaft mbB Georg-Schlosser-Straße 6 35390 Gießen (DE)**

(56) Entgegenhaltungen:
CN-A- 108 572 278      CN-A- 116 298 522
DE-A1- 102011 084 219

**Beschreibung**

Die Erfindung betrifft ein Verfahren zur Isolationsüberwachung einer mit einer Versorgungs-Gleichspannung betriebenen elektrischen Anlage, welche zwischen dem positiven aktiven Leiter und Erde einen ersten Isolationswiderstand und zwischen dem negativen aktiven Leiter und Erde einen zweiten Isolationswiderstand sowie eine Funktionserdung zwischen dem negativen aktiven Leiter und Erde mittels eines Erdungswiderstands (Pfad der Funktionserdung) aufweist.

Weiterhin betrifft die Erfindung eine das erfindungsgemäße Verfahren umsetzende, erfindungsgemäße Isolationsüberwachungs-Anordnung.

Bei erhöhten Anforderungen an die Betriebs-, Brand- und Berührungssicherheit elektrischer Anlagen kommt die Netzform eines ungeerdeten Stromversorgungssystems zum Einsatz, die auch als isoliertes Netz (frz. "Isolé Terre"-IT) oder als IT-Stromversorgungssystem bezeichnet wird. Bei dieser Art des Stromversorgungssystems sind die aktiven Teile von dem Erdpotential - gegen Erde - getrennt. Der Vorteil dieser Netze liegt darin, dass bei einem Isolationsfehler die Funktion der angeschlossenen elektrischen Verbraucher nicht beeinträchtigt wird, da sich wegen des im Idealfall unendlich großen Isolationswiderstandswerts zwischen einem aktiven Leiter des Netzes und Erde kein geschlossener Stromkreis ausbilden kann. Das Netz kann also auch bei einem ersten Isolationsfehler weiter betrieben werden.

Der Widerstand des ungeerdeten Stromversorgungssystems gegen Erde (Isolationswiderstand - im Fehlerfall auch Isolationsfehlerwiderstand oder Fehlerwiderstand) muss daher ständig überwacht werden, da durch einen möglichen weiteren Fehler an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte.

Insbesondere bei elektrischen Anlagen, die von einem ungeerdeten AC-Stromversorgungssystem gespeist werden und über einen AC/DC-Gleichrichter mit einer Versorgungs-Gleichspannung betrieben werden, besteht die Gefahr, dass DC-Streuströme über metallisch leitfähige Anlagenteile und Isolationswiderstandspfade in elektrolytisch leitfähige Anlagenfundamente übergehen. So sind ungeschützte metallische Bauteile, die sich in einer elektrolytischen Umgebung befinden, wie beispielsweise Stahleinlagen in einem Betonfundament oder erdverlegte metallische Vorrichtungen, der Korrosion durch DC-Streuströme aus Stromversorgungsanlagen ausgesetzt. Bei Bauwerken aus Stahlbeton kann der an dem Bewehrungsstahl auftretende Materialabtrag zu einer Schwächung der Statik führen oder bei erdverlegten Rohrleitungen Undichtigkeiten verursachen.

Insbesondere betrifft dies auch Wasserstoffelektrolyseanlagen, bei denen durch elektrolytisch leitfähige Strompfade über einen Verbrauchswasseranschluss des Elektrolyseurs oder einen parasitären elektrolytisch leitfähigen Strompfad Streuströme in dem elektrolytischen Untergrund entstehen können, die in Abhängigkeit der DC-Nennspannung am Elektrolyseur und in Abhängigkeit der Größenordnung der (elektrolytischen) Isolationswiderstandspfade die Lebenszeit der elektrischen Anlage verkürzen.

Im Hinblick auf die Begrenzung der DC-Streuströme und der damit verbundenen Gefahren durch Elektrokorrosion kommt der Isolationsüberwachung besondere Bedeutung zu.

Bei Wasserstoffelektrolyseanlagen gelingt es einigen Herstellern, den Aufbau der elektrischen Anlage so zu gestalten, dass die parasitären elektrolytischen Strompfade nur sehr hochohmig mit Erde in Verbindung kommen. Dabei sind Isolationswiderstandswerte von deutlich über 100Ω/V DC-Nennspannung erreichbar.

Die bei diesem Niveau auftretenden DC-Streuströme sind meistens unkritisch und führen nicht zur einer verkürzten Lebensdauer der Anlage.

Wo dies konstruktionsbedingt nicht erreichbar ist, gehen die Anlagenhersteller dazu über, auf der Gleichspannungsseite der elektrischen Anlage den negativen aktiven Leiter (Minuspol) niederohmig mittels eines Erdungswiderstands mit Erdpotential zu verbinden. Durch diese Funktionserdung wird der potentielle (elektrolytische) Stromfluss über den ersten Isolationswiderstand zwischen dem positiven aktiven Leiter und Erde nicht verändert, jedoch fließt ein Teil dieses Stroms nun nicht mehr über den zwischen dem negativen aktiven Leiter und Erde befindlichen zweiten Isolationswiderstand, sondern über den parallel zu dem zweiten Isolationswiderstand geschalteten Erdungswiderstand der Funktionserdung.

Man ist bestrebt, den metallischen Strompfad über den Erdungswiderstand so niederohmig auszulegen, dass der verbleibende potentielle DC-Streustromanteil über den zweiten Isolationswiderstand nicht zu einer reduzierten Lebensdauer der elektrischen Anlage durch Elektrokorrosion führt.

Die Bestimmung des Isolationswiderstands in Verbindung mit der Funktionserdung stellt jedoch für den Anlagenbetreiber ein Problem dar, da durch diese Funktionserdung eine niederohmige Verbindung zwischen dem negativen aktiven Leiter der elektrischen Anlage und Erde besteht. Bekannterweise wird versucht, den Isolationszustand der elektrischen Anlage über eine DC-Strommessung oder über eine DC-Differenzstrommessung auf der AC-Seite des Gleichrichters abzuschätzen. Da aber, insbesondere bei Wasserstoffelektrolyseuren, teilweise Lastströme im kA-Bereich auftreten, ist diese DC-Strommessung oder DC-Differenzstrommessung auf der AC-Seite nach dem Stand der Technik nicht mit der erforderlichen Genauigkeit umsetzbar, um ungewollte Fehlerströme unterhalb des Bereichs einiger hundert mA feststellen zu können.

Gemäß dem Stand der Technik ist es auch möglich, dass die Funktionserdung über einen sogenannten GFDI (Ground-Fault Detector Interrupter) erfolgt, welcher in bestimmten Zeitintervallen, beispielsweise täglich vor der Inbetriebnahme der elektrischen Anlage, kurzzeitig die Funktionserdung auftrennt, um eine Isolationsüberwachung durchführen zu können. Nachteilig an dieser Lösung ist der benötigte hinreichend hochohmige Trennschalter des GFDIs, der für die volle DC-Nennspannung ausgelegt sein muss. Weiterhin ist es nachteilig, dass nicht über den kompletten Betriebszyklus der elektrischen Anlage hinweg eine weitgehend lückenlose Isolationsüberwachung möglich ist.

Ein weiterer gängiger Lösungsansatz besteht darin, die Funktionserdung über eine überwachte Widerstandserdung des negativen aktiven Leiters gegen Erde zu realisieren. Hier kommt beispielsweise die auf dem US-Markt weit verbreitete NGR (Neutral Ground Resistor) Monitoring-Lösung zum Einsatz. Nachteilig dabei ist jedoch, dass je nach zu erwartender aufgenommener Leistung der elektrischen Anlage für den NGR ein eigener Schaltschrank erforderlich ist und dass je nach Größe des Streustroms und des Widerstandswerts der Spannungsabfall über dem NGR in einem Bereich (>1V DC) liegt, in dem die Streustromkorrosion nicht verhindert werden kann. Dokument CN 116298522A offenbart ein Verfahren zum Korrigieren einer Impedanz eines Isolationserfassungswiderstands eines photovoltaischen Inverters und beinhaltet die Bestimmung einer ersten Isolationsimpedanz der positiven Elektrode und einer zweiten Isolationsimpedanz der negativen Elektrode an Erde. Die Isolationswiderstände werden mit Hilfe des bekannten Isolationserfassungswiderstands oder über Leckströme und Spannungen über die jeweiligen Isolationswiderstände berechnet.

Der vorliegenden Erfindung liegt somit die Aufgabe zugrunde, ein Verfahren und eine dieses Verfahren umsetzende Anordnung zu entwickeln, welche für eine mit einer Versorgungs-Gleichspannung betriebene und eine Funktionserdung aufweisende elektrische Anlage eine zuverlässige Isolationsüberwachung ermöglichen.

Diese Aufgabe wird, bezogen auf ein Verfahren, gelöst durch Messen eines in dem Pfad der Funktionserdung fließenden Erdungsstroms mittels einer DC-Strommesseinrichtung, Messen der Versorgungs-Gleichspannung mittels einer Spannungsmesseinrichtung, Berechnen des ersten Isolationswiderstands aus der Versorgungs-Gleichspannung dividiert durch den Erdungsstrom mittels einer Recheneinheit, wobei während des Betriebs der elektrischen Anlage die Bedingung gilt, dass der zweite Isolationswiderstand mindestens hundertfach größer als der Erdungswiderstand ist.

Der Grundgedanke der vorliegenden Erfindung beruht darauf, in dem Pfad der Funktionserdung eine (hochempfindliche - siehe unten) DC-Strommesseinrichtung anzubringen, welche den über den Erdungswiderstand fließenden Erdungsstrom erfasst, sowie gleichzeitig die Versorgungs-Gleichspannung mittels einer Spannungsmesseinrichtung zu messen.

Die Berechnung des ersten Isolationswiderstands erfolgt dann durch Division der Versorgungs-Gleichspannung durch den Erdungsstrom in einer Recheneinheit.

Grundsätzlich ist also die möglichst genaue Bestimmung nur des ersten Isolationswiderstands von Interesse, da der weitaus größte Teil des Streustroms aufgrund der parallel zu dem zweiten Isolationswiderstand liegenden Funktionserdung über den niederohmigen Erdungswiderstand - und nicht über den parallel liegenden zweiten Isolationswiderstand - fließt. An den zweiten Isolationswiderstand sind lediglich hinsichtlich des Größenverhältnisses zu dem Erdungswiderstand Bedingungen geknüpft.

Im Hinblick auf die Vermeidung einer Elektrokorrosion kommt es darauf an, dass die DC-Spannung zwischen dem negativen aktiven Leiter und Erde, also der DC-Spannungsabfall über dem Erdungswiderstand, so klein ist, dass an der potentiellen Stelle für Elektrokorrosion, nämlich der Strecke über den zweiten Isolationswiderstand - im Fall der Wasserstoffelektrolyseanlage ein elektrolytisch leitfähiger Strompfad über einen Verbrauchswasseranschluss des Elektrolyseurs - keine Korrosionsprozesse gestartet werden. Erfahrungsgemäß ist dies gewährleistet, wenn dieser DC-Spannungsabfall deutlich unter 1V (DC) liegt.

Simulationsergebnisse zeigen, dass eine Isolationsüberwachung mit Bestimmung des ersten Isolationswiderstands dann hinreichend genau erfolgt, wenn während des Betriebs der elektrischen Anlage die Bedingung gilt, dass der zweite Isolationswiderstand mindestens hundertfach größer als der Erdungswiderstand ist.

In weiterer Ausgestaltung ist in dem Pfad der Funktionserdung in Reihe zu dem Erdungswiderstand eine antiparallele Diodenschaltung mit einem zu der antiparallelen Diodenschaltung parallel geschalteten Überbrückungsschalter angeordnet, der zyklisch zwischen einem hochohmigen geöffneten Zustand und einem niederohmigen geschlossenen Zustand wechselt, wobei (über der antiparallelen Diodenschaltung) eine Diodenspannung mittels einer weiteren Spannungsmesseinrichtung gemessen wird, in dem geschlossenen Zustand der erste Isolationswiderstand aus der Versorgungs-Gleichspannung dividiert durch den Erdungsstrom berechnet wird und der zweite Isolationswiderstand durch Division einer Diodenspannungsänderung zwischen den beiden Zuständen und einer Erdungsstromänderung zwischen den beiden Zuständen mittels der Recheneinheit berechnet wird.

Da die Hersteller von funktionsgeerdeten elektrischen Anlagen oftmals nicht einschätzen können, ob die Bedingung für eine hinreichend genaue Isolationsüberwachung - nämlich, dass der zweite Isolationswiderstand mindestens das Hundertfache des Erdungswiderstandes beträgt - betriebsmäßig eingehalten werden kann und damit die realisierte Funktionserdung tatsächlich vor Elektrokorrosion durch DC-Streuströme schützt, wird zur Überprüfung dieser Bedingung der zweite Isolationswiderstand berechnet.

Dazu wird auf der DC-Seite der funktionsgeerdeten elektrischen Anlage in den Pfad der Funktionserdung in Reihe zu dem Erdungswiderstand eine Kombination aus antiparallel geschalteten Dioden mit einem parallel dazu liegenden Überbrückungsschalter eingefügt. Die DC-Entkopplung mittels der antiparallelen Diodenschaltung verhindert das bei nur einer Diode mögliche Auftreten von hohen Sperrspannungen, die parallel liegende Bauelemente zerstören könnten.

Sowohl die Dioden als auch der Überbrückungsschalter sind dabei für den zu erwartenden maximalen Erdungsstrom auszulegen. Die über der antiparallelen Diodenschaltung abfallende DC-Spannung (Diodenspannung) wird gemessen.

Der Überbrückungsschalter wird vorzugsweise durch einen sehr niederohmigen Halbleiterschalter realisiert. Dabei sollte die Größenordnung des Widerstandes im eingeschalteten Zustand des Überbrückungsschalters maximal in der Größenordnung des Erdungswiderstandes liegen.

Der Überbrückungsschalter wird nun so gesteuert, dass er zyklisch zwischen einem hochohmigen geöffneten und einem niederohmigen geschlossenen Zustand wechselt. Die Verweilzeiten für den geöffneten/geschlossenen Zustand werden dabei so gewählt, dass die Messgrößen Erdungsstrom, Erdungsstromänderung, Diodenspannung, Diodenspannungsänderung und Versorgungs-Gleichspannung hinreichend genau erfasst werden können.

Während des geschlossenen Zustands des Überbrückungsschalters, in dem die Diodenschaltung kurzgeschlossen ist, wird der erste Isolationswiderstand - wie bereits im Anspruch 1 ausgeführt - aus der Versorgungs-Gleichspannung dividiert durch den Erdungsstrom berechnet.

Zusätzlich wird nach je einer Periode mit geöffnetem und geschlossenem Zustand des Überbrückungsschalters zyklisch die Diodenspannungsänderung zwischen den beiden Zuständen sowie die Erdungsstromänderung zwischen den beiden Zuständen erfasst und dazu genutzt, den zweiten Isolationswiderstand aus dem Quotient der Diodenspannungsänderung und der Erdungsstromänderung zu berechnen.

Alternativ zu der zuvor beschriebenen Ausführungsart mit antiparalleler Diodenschaltung und Überbrückungsschalter wird in einer weiteren Ausführungsart in den Pfad der Funktionserdung in Reihe zu dem Erdungswiderstand eine antiparallele Diodenschaltung ohne parallel geschalteten Überbrückungsschalter eingefügt, wobei der erste Isolationswiderstand aus der Versorgungs-Gleichspannung dividiert durch den Erdungsstrom mittels der Recheneinheit berechnet wird.

Simulationsergebnisse ergeben, dass auch ohne Bestimmung des zweiten Isolationswiderstands die Bedingung, dass der zweite Isolationswiderstand hundertfach größer als der Erdungswiderstand ist, auch dann hinreichend erfüllt ist, wenn der DC-Spannungsabfall über der antiparallelen Diodenschaltung deutlich oberhalb von einem Prozent der Diodendurchlassspannung liegt.

Hieraus lässt sich die Erkenntnis ableiten, dass auf den Überbrückungsschalter verzichtet werden kann und die über der antiparallelen Diodenschaltung abfallende Diodenspannung in der Weise zu nutzen, dass diese Diodenspannung daraufhin überwacht wird, dass der gemessene Spannungswert deutlich oberhalb von einem Prozent der Diodendurchlassspannung liegt.

In diesem Fall wird davon ausgegangen, dass die Berechnung des ersten Isolationswiderstands aus der Versorgungs-Gleichspannung dividiert durch den Erdungsstrom hinreichend genau erfolgt.

Mit Vorteil wird der mittels der DC-Strommesseinrichtung gemessene Erdungsstrom in einem Bereich kleiner als 100mA erfasst.

Die DC-Strommesseinrichtung ist so auszulegen, dass der Erdungsstrom im Normalbetrieb der elektrischen Anlage messtechnisch hochempfindlich im mA-Bereich unter 100mA erfassbar ist.

Weiter wird ein DC-Fehlerstrom mittels einer in dem Pfad der Funktionserdung installierten DC-Fehlerstrom-Messeinrichtung erfasst.

Zusätzlich kann in allen Ausführungsarten ein ergänzender Fehlerschutz durchgeführt werden, um eine schnelle Abschaltung der elektrischen Anlage bei Auftreten eines personen- oder anlagengefährdenden DC-Fehlerstroms in dem Funktionspfad zu bewirken. Dazu ist in dem Pfad der Funktionserdung eine DC-Fehlerstrom-Messeinrichtung installiert.

Im Unterschied zu der hochempfindlichen DC-Strommesseinrichtung zur Messung des Erdungsstroms ist die DC-Fehlerstrom-Messeinrichtung zur Erfassung des DC-Fehlerstroms für den im Fehlerfall (Erdschluss) auftretenden deutlich höheren Fehlerstrom auszulegen.

Ohne diesen zusätzlichen Fehlerschutz müsste der Funktionserdungspfad eine extrem niederohmige Schleifenimpedanz aufweisen, um eine vorhandene Überstromschutzeinrichtung schnell und zuverlässig auszulösen. Damit müssten auch alle Elemente im Funktionserdungspfad für derartig hohe Ströme - in der Größenordnung von einigen 100A bis in den kA-Bereich - ausgelegt werden.

Mit diesem zusätzlichen Fehlerschutz hingegen kann eine schnell und zuverlässige Abschaltung der elektrischen Anlage bereits bei deutlich kleineren Fehlerströmen im einstelligen Ampere-Bereich bewirkt werden.

Die Bauelemente in dem Pfad der Funktionserdung können kleiner dimensioniert werden und sind somit einfacher und kostengünstiger verfügbar.

Bevorzugt wird der DC-Fehlerstrom mittels einer als Modulares Fehlerstromgerät ausgeführten DC-Fehlerstrom-Messeinrichtung erfasst.

Die Ausgestaltung der DC-Fehlerstrom-Messeinrichtung als (DCsensitives) Modulares Fehlerstromgerät (MRCD) ermöglicht es, durch die in dem MRCD integrierte DC-sensitive Differenzstromüberwachung frühzeitig sich anbahnende Fehlerströme zu erkennen und in Verbindung mit einem externen Schaltglied eine Abschaltung der elektrischen Anlage innerhalb einer normativ vorgeschriebenen Zeit zu bewirken.

Besonders vorteilhaft erweist sich das erfindungsgemäße Verfahren zur Isolationsüberwachung, wenn die mit der Versorgungs-Gleichspannung betriebene elektrische Anlage eine Wasserstoffelektrolyseanlage ist.

Im Zuge der Hinwendung zu regenerativen Energien als Grundlage der Wasserstofferzeugung ist das erfindungsgemäße Verfahren sehr effizient in Verbindung mit dem Betrieb von Wasserstoffelektrolyseanlagen einsetzbar, da aufgrund des elektrolytisch leitenden Verbrauchswasser-Leitungssystems besondere Herausforderungen an die Überwachung des Isolationswiderstands gestellt werden.

Die beanspruchten strukturellen Merkmale der erfindungsgemäßen Isolationsüberwachungs-Anordnung führen die entsprechenden Verfahrensschritte des erfindungsgemäßen Verfahrens zur Isolationsüberwachung aus. Somit treffen die mit dem Verfahren erzielten technischen Wirkungen und daraus resultierenden Vorteile gleichermaßen auch auf die Isolationsüberwachungs-Anordnung zu.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:

**Fig. 1** die Entstehung von Elektrokorrosion durch einen DC-Streustrom in einer Wasserstoffelektrolyseanlage;

**Fig. 2** die Wasserstoffelektrolyseanlage mit einer Funktionserdung;

**Fig. 3** eine erfindungsgemäße Isolationsüberwachungs-Anordnung für die funktionsgeerdete Wasserstoffelektrolyseanlage;

**Fig. 4** Simulationsergebnis des berechneten ersten Isolationswiderstands in Abhängigkeit des zweiten Isolationswiderstands;

**Fig. 5** eine erfindungsgemäße Isolationsüberwachungs-Anordnung mit antiparalleler Diodenschaltung und Überbrückungsschalter;

**Fig. 6** eine erfindungsgemäße Isolationsüberwachungs-Anordnung mit antiparalleler Diodenschaltung ohne Überbrückungsschalter und

**Fig. 7** die Isolationsüberwachungs-Anordnung nach Fig. 6 mit einer DC-Fehlerstrom-Messeinrichtung.

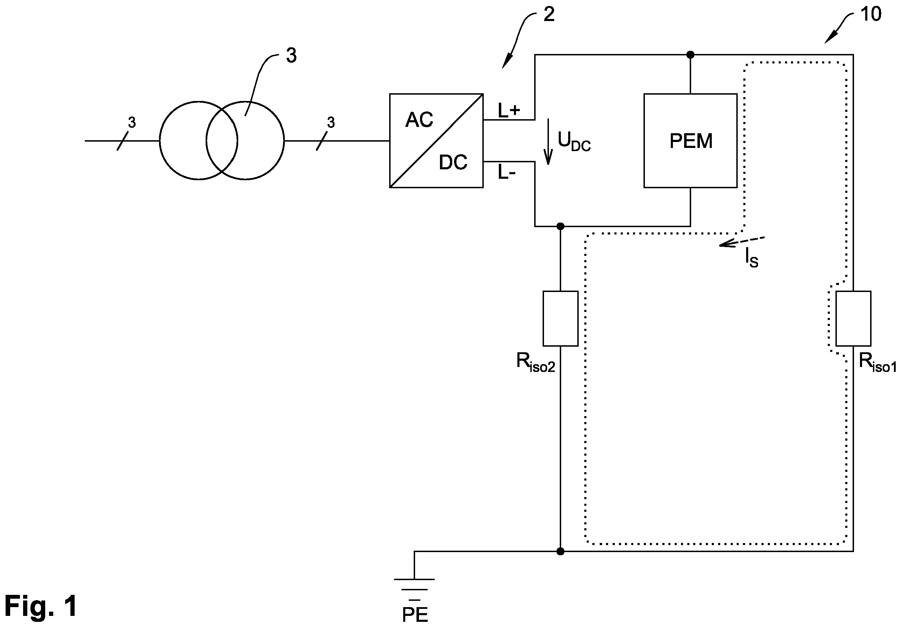

**Fig. 1** zeigt das Entstehen von Elektrokorrosion durch einen DC-Streustrom $I_S$ in einer elektrischen Anlage 2 am Beispiel einer Wasserstoffelektrolyseanlage 2 mit einem PEM (Protonen-Austausch-Membran)-Elektrolyseur.

Der PEM-Elektrolyseur wird von einem dreiphasigen Wechselstromnetz 3 gespeist und ist über einen AC/DC-Gleichrichter an den positiven aktiven Leiter $L_+$ und den negativen aktiven Leiter $L_-$ angeschlossen. Zwischen dem positiven aktiven Leiter $L_+$ und Erde PE ist der Isolationszustand der Wasserstoffelektrolyseanlage 2 durch einen ersten Isolationswiderstand $R_{isol}$ gekennzeichnet, entsprechend ist zwischen dem negativen aktiven Leiter $L_-$ und Erde PE ein zweiter Isolationswiderstand $R_{iso2}$ dargestellt. Die Isolationswiderstände $R_{isol}$ und $R_{iso2}$ können somit einen elektrolytisch leitfähigen Strompfad über den Verbrauchwasseranschluss des PEM-Elektrolyseurs sowie einen parasitären Strompfad aus metallisch leitfähigen Teilen und einem elektrolytisch leitfähigem Untergrund (z. B. dem Fundament aus Beton) ausbilden.

In diesem Stromkreis fließt ein DC-Streustrom $I_S$, der in dem elektrolytisch leitfähigen (Beton-)Boden zu Elektrokorrosion führen kann.

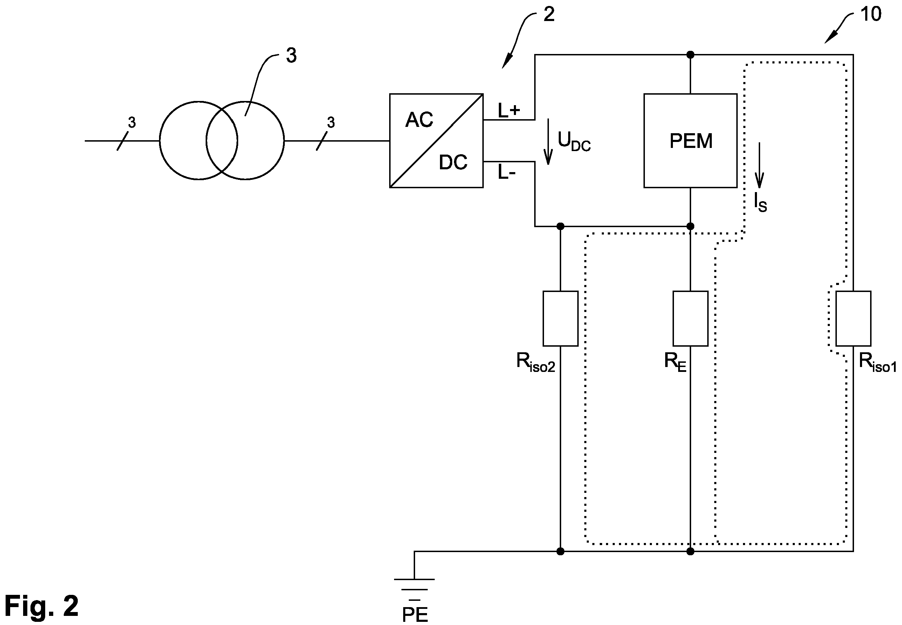

**Fig. 2** zeigt die Wasserstoffelektrolyseanlage 2 mit einer Funktionserdung über einen Erdungswiderstand $R_E$.

Der negative aktive Leiter L- ist über den Erdungswiderstand $R_E$ mit Erde PE verbunden. Da dieser Erdungswiderstand $R_E$ gegenüber dem parallel geschalteten Isolationswiderstand $R_{iso2}$ um ein Vielfaches niederohmiger ausgeführt wird, fließt der überwiegende Anteil des Streustroms $I_S$ als Erdungsstrom $I_E$ über den Pfad der Funktionserdung. Infolge dessen ist durch den nunmehr geringen Streustromanteil über den zweiten Isolationswiderstand $R_{iso2}$ dort die Korrosionsgefahr erheblich verringert.

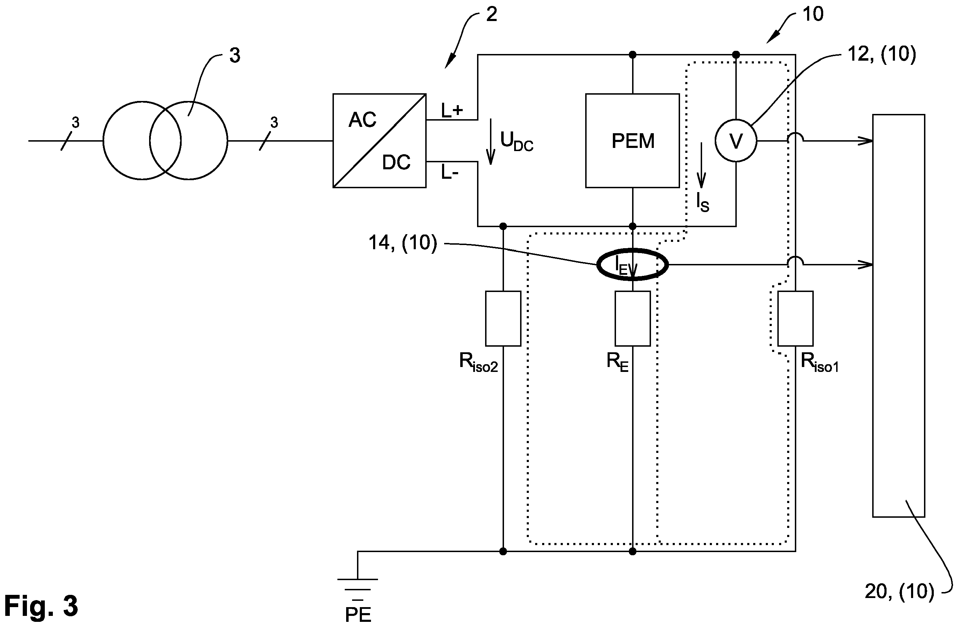

**Fig. 3** zeigt eine erfindungsgemäße Isolationsüberwachungs-Anordnung 10 für die funktionsgeerdete Wasserstoffelektrolyseanlage 2.

Dazu ist in dem Pfad der Funktionserdung eine DC-Strommesseinrichtung 14 vorgesehen, die den über den Erdungswiderstand $R_E$ fließenden Erdungsstrom $I_E$ erfasst. Zur Messung der Versorgungs-Gleichspannung $U_{DC}$ befindet sich eine Spannungsmesseinrichtung 12 zwischen dem positiven aktiven Leiter $L_+$ und dem negativen aktiven Leiter $L_-$. Die Berechnung des ersten Isolationswiderstands $R_{isol}$ erfolgt in einer Recheneinheit 20. Gemäß dem ohmschen Gesetz ergibt sich durch Division der Versorgungs-Gleichspannung $U_{DC}$ durch den Erdungsstrom $I_E$ der erste Isolationswiderstand

$$R_{iso1} = \frac{U_{DC}}{I_E}.$$

Die erfindungsgemäße Isolationsüberwachungs-Anordnung 10 umfasst somit als Hauptkomponenten die Spannungsmesseinrichtung 12, die DC-Strommesseinrichtung 14 sowie die Recheneinheit 20 zur Auswertung der gemessenen Größen und zur Berechnung des ersten (und des zweiten) Isolationswiderstands $R_{iso1}$ ($R_{iso2}$).

Während des Betriebs der Wasserstoffelektrolyseanlage 2 ist die Bedingung einzuhalten, dass der zweite Isolationswiderstand $R_{iso2}$ mindestens hundertfach größer ist als der Erdungswiderstand $R_E$, damit der möglicherweise korrosionserzeugende Streustromanteil über den zweiten Isolationswiderstand $R_{iso2}$ gering ist.

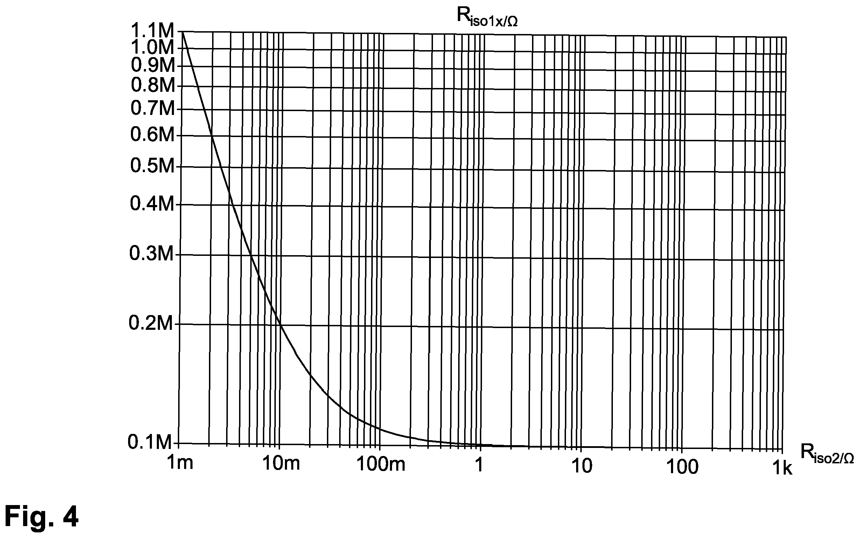

**Fig. 4** zeigt ein Simulationsergebnis des berechneten ersten Isolationswiderstands $R_{iso1}$ in Abhängigkeit des zweiten Isolationswiderstands $R_{iso2}$.

In der Praxis ist es für viele Hersteller von funktionsgeerdeten Wasserstoffelektrolyseanlagen 2 schwierig, einzuschätzen, ob die Bedingung erfüllt ist, dass der zweite Isolationswiderstand $R_{iso2}$ um ein Vielfaches größer ist als der Erdungswiderstand $R_E$ und somit, ob die realisierte Funktionserdung tatsächlich vor Elektrokorrosion durch einen DC-Streustrom $I_S$ schützt.

Um diese Bedingung zu überprüfen, wird mit einem konstanten ersten Isolationswiderstand $R_{iso1}$ von 100kΩ und einem konstanten Erdungswiderstand $R_E$ von 10mΩ der zweite Isolationswiderstand $R_{iso2}$ in einem Bereich von 10mΩ bis 1kΩ in der Simulation schrittweise verändert und der jeweilige Wert des ersten Isolationswiderstands $R_{iso1}$ aus der DC-Nennspannung $U_{DC}$ und dem Erdungsstrom $I_E$ wie oben berechnet.

Aus der Fig. 4 ist ersichtlich, dass der gewünschte Sollwert von 100kΩ des ersten Isolationswiderstands $R_{iso1}$ bei einem zweiten Isolationswiderstandswert von $R_{iso2}$=1Ω erreicht wird. Als Bedingung kann somit gelten, dass der zweite Isolationswiderstand $R_{iso2}$ (=1Ω) um das Hundertfache größer als der Erdungswiderstand $R_E$ (=10mΩ) sein sollte.

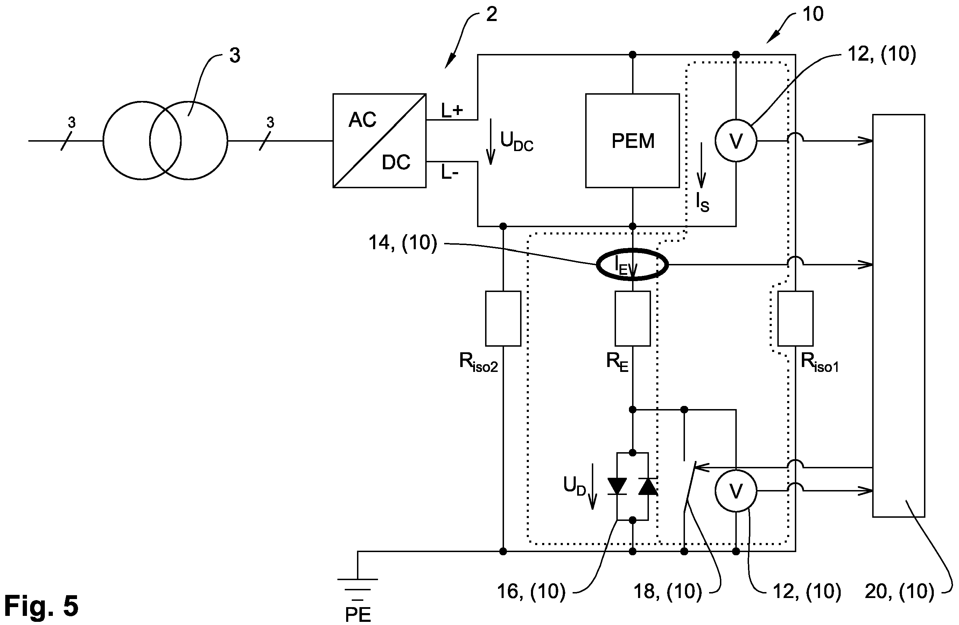

**Fig. 5** zeigt eine erfindungsgemäße Isolationsüberwachungs-Anordnung 10 mit antiparalleler Diodenschaltung 16 und Überbrückungsschalter 18.

Die erfindungsgemäße Isolationsüberwachungs-Anordnung 10 umfasst in diesem Ausführungsbeispiel zusätzlich die antiparallele Diodenschaltung 16 mit einer weiteren Spannungsmesseinrichtung 12 und den Überbrückungsschalter 18. Dabei ist in dem Pfad der Funktionserdung die antiparallele Diodenschaltung 16 in Reihe zu dem Erdungswiderstand $R_E$ geschaltet und parallel zu der antiparallelen Diodenschaltung 16 ist der Überbrückungsschalter 18 angeordnet. Der Überbrückungsschalter 18 wird zyklisch zwischen einem hochohmigen geöffneten Zustand und einem niederohmigen geschlossenen Zustand über Steuersignale aus der Recheneinheit 20 umgeschaltet.

In dem geschlossenen Zustand des Überbrückungsschalters 20 wird die Diodenschaltung 16 kurzgeschlossen, so dass sich - wie oben beschrieben - bei niederohmigem Erdungswiderstand $R_E$ der erste Isolationswiderstand $R_{iso1}$ aus der Versorgungs-Gleichspannung $U_{DC}$ dividiert durch den Erdungsstrom $I_E$ ergibt.

Der zweite Isolationswiderstand $R_{iso2}$ wird durch Division der Spannungsänderung $\Delta U_D$ zwischen den beiden Zuständen und der Stromänderung $\Delta I_E$ zwischen den beiden Zuständen berechnet

$$R_{iso2} = \frac{\Delta U_D}{\Delta I_E}.$$

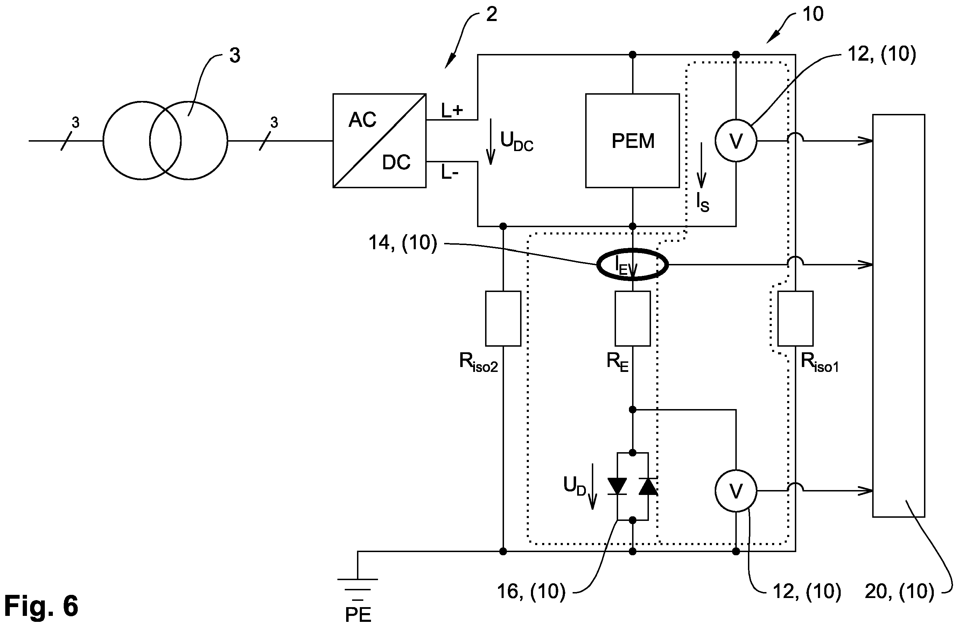

**Fig. 6** zeigt in einer weiteren Ausführungsform eine erfindungsgemäße Isolationsüberwachung 10 mit antiparalleler Diodenschaltung 16 ohne Überbrückungsschalter 18.

Simulationsergebnisse lassen erkennen, dass auch ohne Bestimmung des zweiten Isolationswiderstands $R_{iso2}$ angenommen werden kann, dass die Bedingung, dass der zweite Isolationswiderstand $R_{iso2}$ um das Hundertfache größer als der Erdungswiderstand $R_E$ sein soll, dann erfüllt ist, wenn der DC-Spannungsabfall $U_D$ über der antiparallelen Diodenschaltung 16 deutlich oberhalb von einem Prozent der Diodendurchlassspannung liegt. In diesem Fall kann in dieser optimierten Ausführungsform auf den Überbrückungsschalter 18 verzichtet werden und der DC-Spannungsabfall $U_D$ über der antiparallelen Diodenschaltung 16 wird daraufhin überwacht, dass dieser Spannungswert noch deutlich oberhalb von einem Prozent der Diodendurchlassspannung liegt.

In diesem Fall wird davon ausgegangen, dass die Berechnung des ersten Isolationswiderstands $R_{iso1}$ aus der Division der DC-Nennspannung $U_{DC}$ durch den Erdungsstrom $I_E$ hinreichend genau folgt.

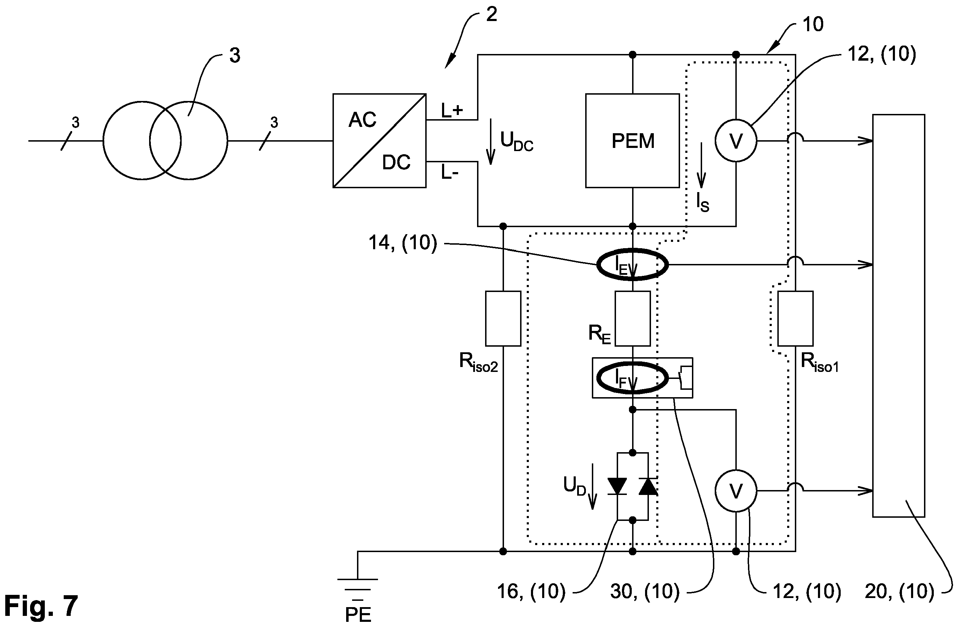

**Fig. 7** zeigt die erfindungsgemäße Isolationsüberwachung nach Fig. 6 mit einer DC-Fehlerstrom-Messeinrichtung 30.

Um eine schnelle Abschaltung der elektrischen Anlage 2 bei Auftreten eines in dem Pfad der Funktionserdung fließenden DC-Fehlerstroms $I_F$ zu bewirken, ist eine zusätzliche DC-Fehlerstrommesseinrichtung 30 in dem Funktionserdungspfad installiert.

Während die DC-Strommesseinrichtung 14 die Aufgabe hat, den Erdungsstrom $I_E$ im Normalbetrieb möglichst empfindlich messtechnisch zu erfassen, wird die zusätzliche DC-Fehlerstrommesseinrichtung 30 für einen im Fehlerfall (Erdschluss) auftretenden deutlich höheren Fehlerstrom $I_F$ ausgelegt.

Vorzugsweise ist die DC-Fehlerstrommesseinrichtung 30 als DCsensitives Modulares Fehlerstromgerät (MRCD) ausgeführt.

## Patentansprüche

1. Verfahren zur Isolationsüberwachung einer mit einer Versorgungs-Gleichspannung ($U_{DC}$) betriebenen elektrischen Anlage (2), welche zwischen dem positiven aktiven Leiter (L+) und Erde (PE) einen ersten Isolationswiderstand ($R_{iso1}$) und zwischen dem negativen aktiven Leiter (L-) und Erde (PE) einen zwei-

ten Isolationswiderstand ($R_{iso2}$) sowie eine Funktionserdung zwischen dem negativen aktiven Leiter (L-) und Erde (PE) mittels eines Erdungswiderstands ($R_E$) aufweist, umfassend die Verfahrensschritte:

Messen eines in dem Pfad der Funktionserdung fließenden Erdungsstroms ($I_E$) mittels einer DC-Strommesseinrichtung (14),
Messen der Versorgungs-Gleichspannung ($U_{DC}$) mittels einer Spannungsmesseinrichtung (12),
Berechnen des ersten Isolationswiderstands ($R_{iso1}$) aus der Versorgungs-Gleichspannung ($U_{DC}$) dividiert durch den Erdungsstrom ($I_E$) mittels einer Recheneinheit (20),
wobei während des Betriebs der elektrischen Anlage (2) die Bedingung gilt, dass der zweite Isolationswiderstand ($R_{iso2}$) mindestens hundertfach größer als der Erdungswiderstand ($R_E$) ist.

2. Verfahren nach Anspruch 1,
**dadurch gekennzeichnet,**

**dass** in dem Pfad der Funktionserdung in Reihe zu dem Erdungswiderstand ($R_E$) eine antiparallele Diodenschaltung (16) mit einem zu der antiparallelen Diodenschaltung (16) parallel geschaltetem Überbrückungsschalter (18) angeordnet ist, der zyklisch zwischen einem hochohmigen geöffneten Zustand und einem niederohmigen geschlossenen Zustand wechselt, wobei
eine Diodenspannung ($U_D$) mittels einer weiteren Spannungsmesseinrichtung (12) gemessen wird,
in dem geschlossenen Zustand der erste Isolationswiderstand ($R_{iso1}$) aus der Versorgungs-Gleichspannung ($U_{DC}$) dividiert durch den Erdungsstrom ($I_E$) berechnet wird und
der zweite Isolationswiderstand ($R_{iso2}$) durch Division einer Diodenspannungsänderung ($\Delta U_D$) zwischen den beiden Zuständen und einer Erdungsstromänderung ($\Delta I_E$) zwischen den beiden Zuständen mittels der Recheneinheit (20) berechnet wird.

3. Verfahren nach Anspruch 1,
**dadurch gekennzeichnet,**
**dass** in dem Pfad der Funktionserdung in Reihe zu dem Erdungswiderstand ($R_E$) eine antiparallele Diodenschaltung (16) ohne parallelgeschalteten Überbrückungsschalter (18) angeordnet ist, wobei der erste Isolationswiderstand ($R_{iso1}$) aus der Versorgungs-Gleichspannung ($U_{DC}$) dividiert durch den Erdungsstrom ($I_E$) mittels der Recheneinheit (20) berechnet wird.

4. Verfahren nach einem der Ansprüche 1 bis 3,
**dadurch gekennzeichnet,**
**dass** der mittels der DC-Strommesseinrichtung (14) gemessene Erdungsstrom ($I_E$) in einem Bereich kleiner als 100mA erfasst wird.

5. Verfahren nach einem der Ansprüche 1 bis 4,
**dadurch gekennzeichnet,**
**dass** ein DC-Fehlerstrom ($I_F$) mittels einer in dem Pfad der Funktionserdung installierten DC-Fehlerstrom-Messeinrichtung (30) erfasst wird.

6. Verfahren nach Anspruch 5,
**dadurch gekennzeichnet,**
**dass** der DC-Fehlerstrom ($I_F$) mittels einer als Modulares Fehlerstromgerät ausgeführten DC-Fehlerstrom-Messeinrichtung (30) erfasst wird.

7. Anwendung des Verfahrens zur Isolationsüberwachung nach einem der Ansprüche 1 bis 6,
**dadurch gekennzeichnet,**
**dass** die mit der Versorgungs-Gleichspannung ($U_{DC}$) betriebene elektrische Anlage (2) eine Wasserstoffelektrolyseanlage ist.

8. Isolationsüberwachungs-Anordnung (10) für eine mit einer Versorgungs-Gleichspannung ($U_{DC}$) betriebene elektrische Anlage, welche zwischen dem positiven aktiven Leiter (L+) und Erde (PE) einen ersten Isolationswiderstand ($R_{iso1}$) und zwischen dem negativen aktiven Leiter (L-) und Erde (PE) einen zweiten Isolationswiderstand ($R_{iso2}$) sowie eine zwischen dem negativen aktiven Leiter (L-) und Erde (PE) eine Funktionserdung mittels eines Erdungswiderstands ($R_E$) aufweist, mit einer DC-Strommesseinrichtung (14) zur Messung eines in dem Pfad der Funktionserdung fließenden Erdungsstroms ($I_E$), einer Spannungsmesseinrichtung (12) zur Messung der Versorgungs-Gleichspannung ($U_{DC}$), einer Recheneinheit (20), welche ausgelegt ist zur Berechnung des ersten Isolationswiderstands ($R_{iso1}$) aus der Versorgungs-Gleichspannung ($U_{DC}$) dividiert durch den Erdungsstrom ($I_E$),
wobei während des Betriebs der elektrischen Anlage (2) die Bedingung gilt, dass der zweite Isolationswiderstand ($R_{iso2}$) mindestens hundertfach größer als der Erdungswiderstand ($R_E$) ist.

9. Isolationsüberwachungs-Anordnung (10) nach Anspruch 8,
**dadurch gekennzeichnet,**
**dass** in dem Pfad der Funktionserdung in Reihe zu dem Erdungswiderstand ($R_E$) eine antiparallele Diodenschaltung (16) mit einem zu der antiparallelen Diodenschaltung (16) parallel geschaltetem Überbrückungsschalter (18) angeordnet ist, der zyklisch zwischen einem hochohmigen geöffneten Zustand und einem niederohmigen geschlossenen Zustand wechselt, wobei die Recheneinheit (20) ausgelegt ist zur Berechnung des ersten Isolationswiderstands ($R_{iso1}$) aus der Versorgungs-Gleichspannung ($U_{DC}$) dividiert durch den Erdungsstrom ($I_E$) in dem geschlossenen Zustand und zur Berechnung des zweiten Isolationswiderstands ($R_{iso2}$) durch Division der Spannungsänderung ($\Delta U_D$) zwischen den beiden Zuständen und der Stromänderung ($\Delta I_D$) zwischen den beiden Zuständen.

10. Isolationsüberwachungs-Anordnung (10) nach Anspruch 8,
    **dadurch gekennzeichnet,**
    **dass** in dem Pfad der Funktionserdung in Reihe zu dem Erdungswiderstand ($R_E$) eine antiparallele Diodenschaltung (16) angeordnet ist, wobei die Recheneinheit (20) ausgelegt ist zur Berechnung des ersten Isolationswiderstands ($R_{iso1}$) aus der Versorgungs-Gleichspannung ($U_{DC}$) dividiert durch den Erdungsstrom ($I_E$).

11. Isolationsüberwachungs-Anordnung (10) nach einem der Ansprüche 8 bis 10,
    **dadurch gekennzeichnet,**
    **dass** die DC-Strommesseinrichtung (14) hochempfindlich zur Erfassung des Erdungsstroms ($I_E$) im Bereich kleiner als 100mA ausgelegt ist.

12. Isolationsüberwachungs-Anordnung (10) nach einem der Ansprüche 8 bis 11,
    **gekennzeichnet durch,**
    eine in dem Pfad der Funktionserdung installierte DC-Fehlerstrom-Messeinrichtung (30) zur Erfassung eines DC-Fehlerstroms ($I_F$).

13. Isolationsüberwachungs-Anordnung (10) nach Anspruch 12 ,
    **dadurch gekennzeichnet,**
    **dass** die DC-Fehlerstrom-Messeinrichtung als Modulares Fehlerstromgerät ausgeführt ist.

14. Verwendung der Isolationsüberwachungs-Anordnung (10) nach einem der Ansprüche 8 bis 13,
    **dadurch gekennzeichnet,**
    **dass** die elektrische Anlage (2) eine Wasserstoffelektrolyseanlage ist.

**Claims**

1. A method for insulation monitoring of an electric installation (2) which is operated using a supply direct voltage ($U_{DC}$) and has a first insulation resistance ($R_{iso1}$) between the positive active conductor (L+) and ground (PE) and a second insulation resistance ($R_{iso2}$) between the negative active conductor (L-) and ground (PE) as well as a functional grounding between the negative active conductor (L-) and ground (PE) by means of a ground resistance ($R_E$), the method comprising the following steps:

   measuring a ground current ($I_E$), which flows in the path of the functional grounding, by means of a DC measuring device (14), measuring the supply direct voltage ($U_{DC}$) by means of a voltage measuring device (12),
   computing the first insulation resistance ($R_{iso1}$) from the supply direct voltage ($U_{DC}$) divided by the ground current ($I_E$) by means of a computing unit (20),
   the condition being valid during operation of the electric installation (2) that the second insulation resistance ($R_{iso2}$) is at least 100 times greater than the ground resistance ($R_E$).

2. The method according to claim 1,
   **characterized in that**

   an antiparallel diode circuit (16) having a bypass switch (18) switched parallel to the antiparallel diode circuit (16) is disposed in series to the ground resistance ($R_E$) in the path of the functional grounding, the bypass switch (18) cyclically alternating between a high-impedance open state and a low-impedance closed state, a diode voltage ($U_D$) being measured by means of another voltage measuring device (12),
   the first insulation resistance ($R_{iso1}$) being computed in the closed state from the supply direct voltage ($U_{DC}$) divided by the ground current ($I_E$), and
   the second insulation resistance ($R_{iso2}$) being computed by dividing a diode voltage change ($\Delta U_D$) between the two states and a ground current change ($\Delta I_E$) between the two states by means of the computing unit (20).

3. The method according to claim 1,
   **characterized in that**
   an antiparallel diode circuit (16) without a bypass switch (18) switched parallel thereto is disposed in series to the ground resistance ($R_E$) in the path of the functional grounding, the first insulation resistance ($R_{iso1}$) being computed from the supply direct voltage ($U_{DC}$) divided by the ground current ($I_E$) by means of the computing unit (20).

4. The method according to any one of the claims 1 to 3,
   **characterized in that**
   the ground current ($I_E$) measured by means of the DC measuring device (14) is detected in a range less than 100 mA.

5. The method according to any one of the claims 1 to 4,
   **characterized in that**
   a DC residual current ($I_F$) is detected by means of DC residual-current measuring device (30) installed in the path of the functional grounding.

6. The method according to claim 5,
**characterized in that**
the DC residual current ($I_F$) is detected by means of a DC residual-current measuring device (30) configured as a modular residual current device.

7. An application of the method for insulation monitoring according to any one of the claims 1 to 6,
**characterized in that**
the electric installation (2) operated using the supply direct voltage ($U_{DC}$) is a hydrogen electrolysis installation.

8. An insulation monitoring arrangement (10) for an electric installation which is operated using a supply direct voltage ($U_{DC}$) and has a first insulation resistance ($R_{iso1}$) between the positive active conductor (L+) and ground (PE) and a second insulation resistance ($R_{iso2}$) between the negative active conductor (L-) and ground (PE) and a functional grounding between the negative active conductor (L-) and ground (PE) by means of a ground resistance ($R_E$), the insulation monitoring arrangement (10) having a DC measuring device (14) for measuring a ground current ($I_E$) flowing in the path of the functional grounding, a voltage measuring device (12) for measuring the supply direct voltage ($U_{DC}$), a computing unit (20), which is configured for computing the first insulation resistance ($R_{iso1}$) from the supply direct voltage ($U_{DC}$) divided by the ground current ($I_E$),
the condition being valid during operation of the electric installation (2) that the second insulation resistance ($R_{iso2}$) is at least 100 times greater than the ground resistance ($R_E$).

9. The insulation monitoring arrangement (10) according to claim 8,
**characterized in that**
an antiparallel diode circuit (16) having a bypass switch (18) switched parallel to the antiparallel diode circuit (16) is disposed in series to the ground resistance ($R_E$) in the path of the functional grounding, the bypass switch (18) cyclically alternating between a high-impedance open state and a low-impedance closed state, the computing unit (20) being configured for computing the first insulation resistance ($R_{iso1}$) from the supply direct voltage ($U_{DC}$) divided by the ground current ($I_E$) in the closed state and for computing the second insulation resistance ($R_{iso2}$) by dividing the voltage change ($\Delta U_D$) between the two states and the current change ($\Delta I_D$) between the two states.

10. The insulation monitoring arrangement (10) according to claim 8,
**characterized in that**
an antiparallel diode circuit (16) is disposed in series to the ground resistance ($R_E$) in the path of the functional grounding, the computing unit (20) being configured for computing the first insulation resistance ($R_{iso1}$) from the supply direct voltage ($U_{DC}$) divided by the ground current ($I_E$).

11. The insulation monitoring arrangement (10) according to any one of the claims 8 to 10,
**characterized in that**
the DC measuring device (14) is designed to be highly sensitive for detecting the ground current ($I_E$) in the range of less than 100 mA.

12. The insulation monitoring arrangement (10) according to any one of the claims 8 to 11,
**characterized by**
a DC residual-current measuring device (30) installed in the path of the functional grounding and configured for detecting a DC residual current ($I_F$).

13. The insulation monitoring arrangement (10) according to claim 12,
**characterized in that**
the DC residual-current measuring device is configured as a modular residual current device.

14. A usage of the insulation monitoring arrangement (10) according to any one of the claims 8 to 13,
**characterized in that**
the electric installation (2) is a hydrogen electrolysis installation.

**Revendications**

1. Procédé pour surveiller les isolements d'une installation électrique (2) qui fonctionne à l'aide d'une tension continue d'alimentation ($U_{DC}$) et a une première résistance d'isolement ($R_{iso1}$) entre le conducteur actif positif (L+) et la terre (PE) et une deuxième résistance d'isolement ($R_{iso2}$) entre le conducteur actif négatif (L-) et la terre (PE) ainsi qu'une mise à la terre fonctionnelle entre le conducteur actif négatif (L-) et la terre (PE) au moyen d'une résistance de terre ($R_E$),
le procédé comprenant les étapes suivantes :

mesurer un courant de terre ($I_E$), qui circule dans le chemin de la mise à la terre fonctionnelle, au moyen d'un dispositif (14) de mesure en CC,
mesurer la tension continue d'alimentation ($U_{DC}$) au moyen d'un dispositif (12) de mesure en tension,
calculer la première résistance d'isolement ($R_{iso1}$) à partir de la tension continue d'alimentation (U$_{DC}$) divisée par le courant de terre (I$_E$) au moyen d'une unité de calcul (20), la condition étant valable pendant le fonctionnement de l'installation électrique (2) que la deuxième résistance d'isolement (R$_{iso2}$) est au moins 100 fois supérieure à la résistance de terre (R$_E$).

2. Procédé selon la revendication 1,
   **caractérisé en ce**

   **qu'**un circuit de diodes (16) antiparallèle ayant un interrupteur de dérivation (18) commuté en parallèle avec le circuit de diodes (16) antiparallèle est disposé en série avec la résistance de terre (R$_E$) dans le chemin de la mise à la terre fonctionnelle, l'interrupteur de dérivation (18) alternant cycliquement entre un état ouvert à haute impédance et un état fermé à basse impédance,
   une tension de diode (U$_D$) étant mesurée au moyen d'un autre dispositif (12) de mesure en tension,
   la première résistance d'isolement (R$_{iso1}$) étant calculée dans l'état fermé à partir de la tension continue d'alimentation (U$_{DC}$) divisée par le courant de terre (I$_E$), et
   la deuxième résistance d'isolement (R$_{iso2}$) étant calculée en divisant le changement ($\Delta U_D$) de tension de diode entre les deux états et le changement ($\Delta I_E$) de courant de terre entre les deux états au moyen de l'unité de calcul (20).

3. Procédé selon la revendication 1,
   **caractérisé en ce**
   **qu'**un circuit de diode (16) antiparallèle sans interrupteur de dérivation (18) commuté en parallèle à celui-ci est disposé en série avec la résistance de terre (R$_E$) dans le chemin de la mise à la terre fonctionnelle, la première résistance d'isolement (R$_{iso1}$) étant calculée à partir de la tension continue d'alimentation (U$_{DC}$) divisée par le courant de terre (I$_E$) au moyen de l'unité de calcul (20).

4. Procédé selon l'une quelconque des revendications 1 à 3,
   **caractérisé en ce que**
   le courant de terre (I$_E$) mesuré au moyen du dispositif (14) de mesure en CC est détecté dans une plage inférieure à 100 mA.

5. Procédé selon l'une quelconque des revendications 1 à 4,
   **caractérisé en ce**
   **qu'**un courant continu différentiel résiduel (I$_F$) est détecté au moyen d'un dispositif de mesure (30) d'un courant continu différentiel résiduel installé dans le chemin de la mise à la terre fonctionnelle.

6. Procédé selon la revendication 5,
   **caractérisé en ce que**
   le courant continu différentiel résiduel (I$_F$) est détecté au moyen d'un dispositif de mesure (30) d'un courant continu différentiel résiduel configuré comme un dispositif modulaire d'un courant continu différentiel résiduel.

7. Application du procédé pour surveiller des isolements selon l'une quelconque des revendications 1 à 6,
   **caractérisé en ce que**
   l'installation électrique (2) fonctionnant à l'aide de la tension continue d'alimentation (U$_{DC}$) est une installation d'électrolyse de l'eau.

8. Agencement (10) de surveillance d'isolements pour une installation électrique fonctionnant avec une tension continue d'alimentation (U$_{DC}$) et ayant une première résistance d'isolement (R$_{iso1}$) entre le conducteur actif positif (L+) et la terre (PE) et une deuxième résistance d'isolement (R$_{iso2}$) entre le conducteur actif négatif (L-) et la terre (PE) ainsi qu'une mise à la terre fonctionnelle entre le conducteur actif négatif (L-) et la terre (PE) au moyen d'une résistance de terre (R$_E$), l'agencement (10) de surveillance d'isolements ayant un dispositif (14) de mesure en CC pour mesurer un courant de terre (I$_E$) circulant dans le chemin de la mise à la terre fonctionnelle, un dispositif (12) de mesure en tension pour mesurer la tension continue d'alimentation (U$_{DC}$), une unité de calcul (20), qui est configurée pour calculer la première résistance d'isolement (R$_{iso1}$) à partir de la tension continue d'alimentation (U$_{DC}$) divisée par le courant de terre (I$_E$),
   la condition étant valable pendant le fonctionnement de l'installation électrique (2) que la deuxième résistance d'isolement (R$_{iso2}$) est au moins 100 fois supérieure à la résistance de terre (R$_E$).

9. Agencement (10) de surveillance d'isolements selon la revendication 8,
   **caractérisé en ce**
   **qu'**un circuit de diodes (16) antiparallèle ayant un interrupteur de dérivation (18) commuté en parallèle avec le circuit de diodes (16) antiparallèle est disposé en série avec la résistance de terre (R$_E$) dans le chemin de la mise à la terre fonctionnelle, l'interrupteur de dérivation (18) alternant cycliquement entre un état ouvert à haute impédance et un état fermé à basse impédance, l'unité de calcul (20) étant configurée pour calculer la première résistance d'isolement (R$_{iso1}$) à partir de la tension continue d'alimentation (U$_{DC}$) divisée par le courant de terre (I$_E$) dans l'état fermé et pour calculer la deuxième résistance d'isolement (R) (R$_{(iso2)}$) en divisant le changement de tension ($\Delta U_D$) entre les deux états et le changement de courant ($\Delta I_D$) entre les deux états.

**10.** Agencement (10) de surveillance d'isolements selon la revendication 8,
**caractérisé en ce**
**qu'**un circuit de diode (16) antiparallèle est disposé en série avec la résistance de terre ($R_E$) dans le chemin de la mise à la terre fonctionnelle, l'unité de calcul (20) étant configurée pour calculer la première résistance d'isolement ($R_{iso1}$) à partir de la tension continue d'alimentation ($U_{DC}$) divisée par le courant de terre ($I_E$).

**11.** Agencement (10) de surveillance d'isolements selon l'une quelconque des revendications 8 à 10,
**caractérisé en ce que**
le dispositif (14) de mesure en CC est conçu pour être hautement sensible afin de détecter le courant de terre ($I_E$) dans une plage inférieure à 100 mA.

**12.** Agencement (10) de surveillance d'isolements selon l'une quelconque des revendications 8 à 11,
**caractérisé par**
un dispositif de mesure (30) d'un courant continu différentiel résiduel installé dans le chemin de la mise à la terre fonctionnelle et configuré pour détecter un courant continu différentiel résiduel ($I_F$).

**13.** Agencement (10) de surveillance d'isolements selon la revendication 12,
**caractérisé en ce que**
le dispositif de mesure d'un courant continu différentiel résiduel est configuré comme un dispositif modulaire d'un courant continu différentiel résiduel.

**14.** Utilisation d'un agencement (10) de surveillance d'isolements selon l'une quelconque des revendications 8 à 13,
**caractérisé en ce que**
l'installation électrique (2) est une installation d'électrolyse de l'eau.

Fig. 1

EP 4 564 020 B1

**Fig. 2**

EP 4 564 020 B1

**Fig. 3**

**Fig. 4**

EP 4 564 020 B1

**Fig. 5**

EP 4 564 020 B1

16

**Fig. 6**

EP 4 564 020 B1

Fig. 7

EP 4 564 020 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 116298522 A